# FASCICULE DE BREVET EUROPEEN

(11) **EP 0 915 540 B1**
(45) Date de publication et mention de la délivrance du brevet: **12.02.2003**
(21) Numéro de dépôt: 98402746.6
(22) Date de dépôt: 05.11.1998
(51) Int. Cl.: H01S 5/02, H01S 5/068

(54) **Dispositif d'émission optique à composant intégré comportant au moins une section laser et une section de modulation**
Integrierte lichtemittierende Vorrichtung, die mindestens einen Laserabschnitt und einen Modulatorabschnitt enthält
Integrated light emitting device comprising at least a laser section and a modulation section

(30) Priorité: 06.11.1997 FR 9713951
(43) Date de publication de la demande: 12.05.1999
(73) Titulaire: ALCATEL, 75008 Paris (FR)
(72) Inventeur: Brosson, Philippe, 91470 Forges-les-Bains (FR); Lestra, Alexis, 91400 Orsay (FR); Hebert, Jean-Paul, 78470 Saint-Remy les Chevreuse (FR)
(74) Mandataire: Fournier, Michel Robert Marie

(56) Documents cités:
- EP-A- 0 671 791
- EP-A- 0 712 180
- US-A- 5 418 800
- YAMAGUCHI M ET AL: "REQUIREMENTS FOR MODULATOR-INTEGRATED DFB LD'S FOR PENALTY-FREE 2.5-GB/S TRANSMISSION" JOURNAL OF LIGHTWAVE TECHNOLOGY, vol. 13, no. 10, 1 octobre 1995, pages 1948-1954, XP000596072
- ANDREKSON P A ET AL: "ELECTRICAL MODE-HOPPING NOISE IN EXTERNAL-CAVITY SEMICONDUCTOR LASERS AND MODE-HOPPING ELIMINATION BY A NONOPTICAL CONTROL LOOP" IEEE JOURNAL OF QUANTUM ELECTRONICS, vol. QE-23, no. 12, décembre 1987, pages 2078-2083, XP000705852
- E. GOOBAR ET AL: "Measurements and theory of correlation between terminal electrical noise and optical noise in a two-section semiconductor laser" IEEE JOURNAL OF QUANTUM ELECTRONICS., vol. 29, no. 2, février 1993, pages 386-395, XP002072952 NEW YORK US
- W. FANG ET AL: "modeling and experiment of 1.55 mum integrated electroabsorption modulator with distributed feedback laser" PROCEEDINGS OF THE SPIE, THE INTERNATIONAL SOCIETY FOR OPTICAL ENGINEERING, CONFERENCE ON OPTOELECTRONIC INTEGRATEDCIRCUITS SAN JOSE CA. USA 12-14 FEBRUARY 1997, vol. 3006, pages 207-215, XP002073189

## Description

L'invention se rapporte à un dispositif d'émission optique, comprenant un composant intégré comportant au moins une section laser et une section de modulation de la puissance optique de l'onde fournie par la section laser.

Dans les systèmes de transmission optique à haut débit, la variation de fréquence optique des impulsions en sortie du modulateur conditionne la distance maximale de transmission.

Dans un système de transmission optique utilisant comme émetteur un composant intégré à section laser et section de modulation, appelé dans la suite dispositif ILM (pour *Integrated Laser Modulator)*, cette variation de fréquence a en fait trois composantes, à savoir une variation de fréquence transitoire (*transient chirp dans la littérature anglo-saxonne*), *une* variation de fréquence adiabatique (*adiabatic chirp*) et une oscillation (*oscillating chirp*).

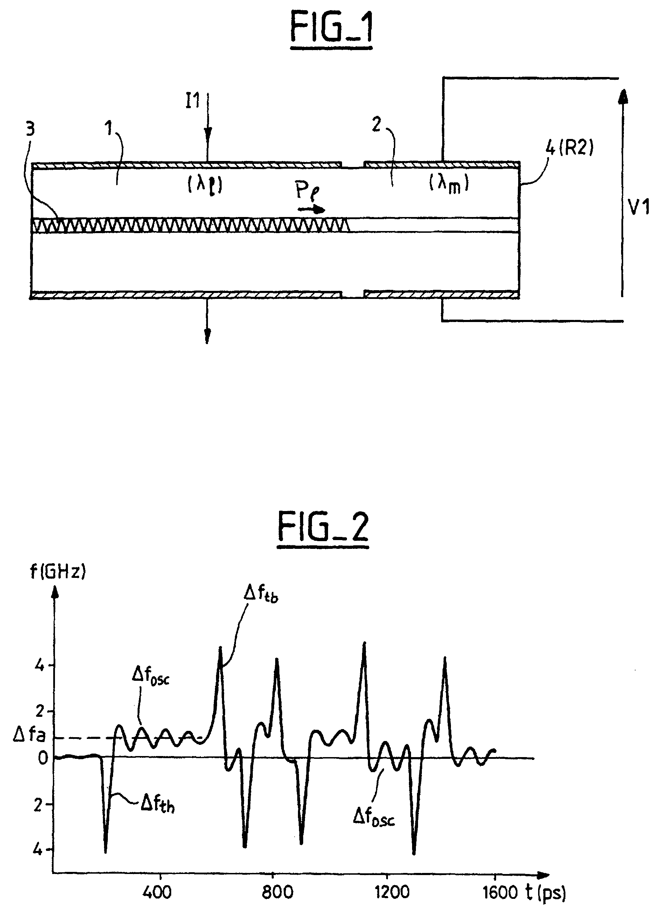

Un dispositif ILM est représenté schématiquement sur la figure 1. C'est un dispositif semi-conducteur comportant au moins une section oscillateur laser 1 et une section de modulation 2. La section 1 comprend un réseau distribué 3, dit réseau de Bragg, le long de l'axe longitudinal de propagation et fournit vers la section de modulation 2 de l'énergie lumineuse de puissance P_{*l*} à une fréquence donnée (ou longueur d'onde donnée λₗ) sélectionnée par le réseau distribué, en réponse à une injection transversale de courant électrique I1 dans la section laser.

La section de modulation 2 est une section électro-absorbante commandée par une tension modulée V1 représentative d'un signal à émettre. Cette section est traitée pour avoir une bande interdite supérieure à celle de la section laser, de manière à ce que la longueur d'onde laser λₗ soit supérieure de plusieurs nanomètres (10 à 50 nanomètres par exemple) à la longueur d'onde λₘ de la section de modulation. Ainsi, cette section de modulation polarisée par un niveau de tension V1 nul (V1= 0) sera-t-elle transparente pour la lumière émise par la section laser et complètement absorbante pour un niveau de tension négatif. Cette modulation en tout ou rien est réalisée par le signal de tension V1, correspondant à la suite de bits à transmettre à la fréquence de transmission du système de transmission optique. Ainsi, la transmission d'un "1" se fait en appliquant un niveau de tension 0 et la transmission d'un "0" se fait en appliquant un niveau de tension négatif. On récupère ainsi sur la face de sortie de la section de modulation des impulsions optiques codées. La face 4 de sortie du modulateur est traitée antireflet pour avoir un faible coefficient de réflexion R2.

Ce dispositif ILM entraîne comme indiqué précédemment trois types de variation de fréquence optique.

La variation de fréquence transitoire est la variation de fréquence sur les transitions hautes et basses des impulsions due à la modulation en tout ou rien. Cette modulation en tout ou rien entraîne en effet une variation de l'indice de réfraction dans cette section au moment des transitions hautes et basses. Cela produit une variation de la phase sur la face de sortie du modulateur. C'est ce qui fait varier la fréquence de l'impulsion sur les fronts montants et descendants de l'impulsion optique, avec en pratique un décalage dans le rouge ou le bleu en sortie de section de modulation.

Les variations de fréquence adiabatique et les oscillations sont dues à la structure intégrée du modulateur avec le laser. Bien que traitée antireflet, la face 4 de sortie du modulateur a un coefficient de réflexion R2 non nul. La perte optique dans le modulateur est donc modulée. La modulation résiduelle de cette perte optique entraîne une variation de la densité de porteurs dans la section laser. Ceci fait varier l'indice de réfraction dans la section laser, et donc la longueur d'onde laser λₗ change. La composante statique de cette variation est la variation de fréquence adiabatique qui consiste en une fréquence différente entre les niveaux haut et bas stabilisés d'une impulsion optique en sortie du modulateur. La composante dynamique de cette variation consiste en des oscillations sur chacun des niveaux haut/bas.

Ces différentes variations de fréquence sont représentées sur la figure 2. Elles correspondent à une suite d'impulsions optiques en sortie de section de modulation. On distingue la variation de fréquence de transition sur les fronts montants Δfₜₕ et descendants Δf_{tb}. La variation de fréquence adiabatique, qui a dans l'exemple représenté une amplitude positive Δfₐ de l'ordre de un gigaherz et les oscillations Δf_{osc} sur les états hauts et bas. Or, ces variations de fréquence affectent directement la qualité de la transmission optique. Il convient donc de contrôler ces variations de fréquence pour optimiser la qualité de transmission et permettre ainsi d'augmenter la distance entre les répéteurs des liaisons optiques.

pour contrôler la variation de fréquence transitoire, une solution connue de l'état de la technique consiste à prévoir une troisième section, dite section de phase, après la section de modulation. Cette section de phase est commandée par un signal de tension en opposition de phase avec le signal de commande V1 de la section de modulation. De cette manière, on compense la variation d'indice de réfraction dans la section de modulation, ce qui permet de supprimer ou d'atténuer la variation de fréquence transitoire. Cependant, cette solution ignore les problèmes de réflectivité sur la face de sortie du circuit modulateur et donc ne résout en rien les problèmes de variation de fréquence adiabatique et d'oscillations sur les niveaux hauts et bas des impulsions optiques. En outre, la section de phase doit avoir une composition différente des autres sections (longueur d'onde différente de la longueur d'onde laser λₗ et du modulateur λₘ), ce qui implique des étapes de fabrication supplémentaires (épitaxie). En outre, les solutions de compensation basées sur des signaux de modulation en opposition de phase sont toujours complexes. Enfin, la modulation de la section de phase entraîne des pertes optiques supplémentaires.

En ce qui concerne la variation de fréquence adiabatique et les oscillations, on a pu observer que l'amplitude des oscillations diminue avec l'amplitude de la variation de fréquence adiabatique. Diminuer cette dernière, c'est donc réduire aussi les oscillations. On s'intéresse donc plus particulièrement aux variations de fréquence adiabatiques. La variation de fréquence adiabatique varie avec la valeur de la phase Ω de l'onde sur la face de sortie de la section de modulation. La valeur de la phase elle-même est fonction de la position du réseau par rapport à la face de sortie. Aussi la valeur de la variation de fréquence adiabatique pour un dispositif ILM est-elle très aléatoire. Cependant, pour les dispositifs ILM d'une même série de fabrication, on connaît son amplitude maximum (en valeur absolue).

Une méthode habituellement utilisée consiste à trier les composants et ne retenir que les composants à faible variation de fréquence adiabatique.

Pour réduire la variation de fréquence adiabatique, on effectue aussi un traitement de la face de sortie du modulateur, pour qu'elle soit revêtue de matériaux antireflet, de manière à avoir une réflectivité R2 la plus faible possible. Au prix d'un procédé de fabrication complexe, on arrive ainsi à une réflectivité R2 de l'ordre de 2x10⁻⁴ contre une réflectivité de l'ordre de 10⁻³, 10⁻² obtenue par les procédés de fabrication courants. Cependant, ces deux méthodes combinées de tri des composants selon leurs performances et de réduction drastique du coefficient de réflexion R2 ont une répercussion non négligeable sur les coûts de fabrication et en outre, offrent un rendement très limité.

Ainsi l'état de la technique n'offre pas de solutions satisfaisantes à la réduction de la variation de fréquence adiabatique et des oscillations sur les impulsions lumineuses en sortie.

Un objet de l'invention est de proposer une solution simple et efficace à ce problème technique.

EP-A-0 712 180 divulge un dispositif d'émission optique selon le préambule de la revendication 1.

Expérimentalement, on a pu vérifier que l'amplitude de la variation de fréquence adiabatique est une fonction périodique de la phase Ω de l'onde sur la face de sortie du modulateur. Il existe aussi une valeur de la phase Ω pour laquelle l'amplitude de la variation de fréquence adiabatique est nulle (ou égale à une valeur donnée). Dans l'invention, on a ainsi recherché une solution technique permettant de déterminer la valeur de phase Ω pour laquelle la variation de fréquence adiabatique a la valeur désirée et permettant d'agir sur le dispositif ILM pour obtenir ladite valeur de phase.

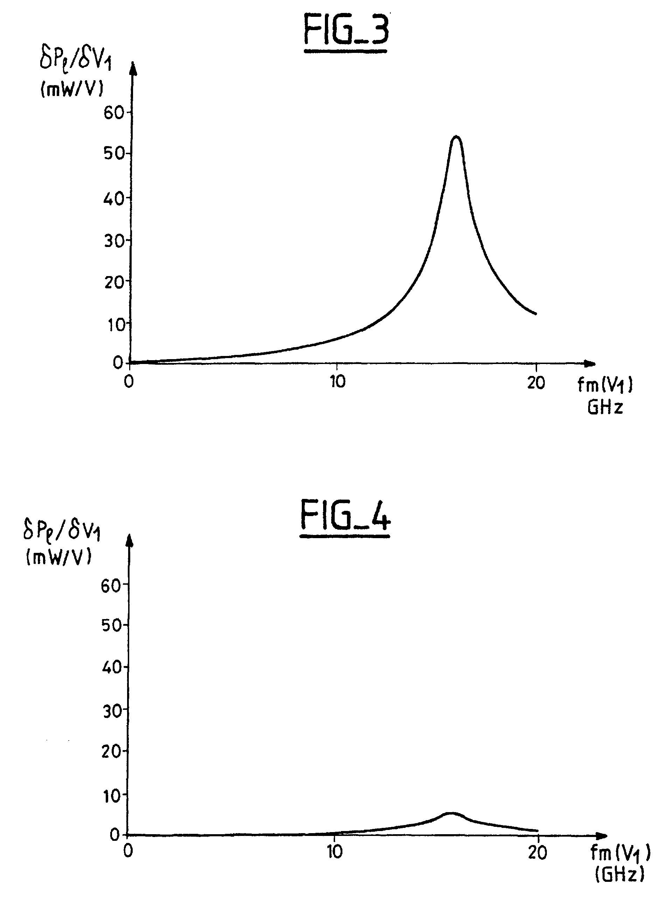

Or, on observe une modulation de la puissance optique P_{*l*} et de la tension de la section laser par la modulation de la tension de commande V1 de la section de modulation. Les simulations numériques de la modulation de puissance δP_{*l*}/δV1 par la modulation de la tension V1 montrent que lorsque la phase Ω est ajustée pour avoir une amplitude nulle de la variation de fréquence adiabatique, la modulation de, la puissance laser P_{*l*} (face arrière) est minimum. Il en est de même de la modulation de la tension laser V_{*l*}. Les figures 3 et 4 représentent ces courbes δP_{*l*}/δV1. La première pour une variation de fréquence adiabatique d'amplitude positive de l'ordre de 1 GHz, montre une forte résonance. La deuxième pour une variation de fréquence adiabatique d'amplitude nulle, est fortement réduite.

La solution technique au problème posé dans l'invention repose sur cette observation. En mesurant l'amplitude de la modulation de la tension aux bornes de la section laser, il est possible de déterminer et d'ajuster la phase en sortie de la section de modulation. Ainsi, si par exemple l'amplitude de cette modulation de tension est minimum, l'amplitude correspondante de la variation de fréquence adiabatique sera nulle.

Si on veut positionner l'amplitude de la variation de fréquence adiabatique à une valeur déterminée, non nulle, il faut en outre calibrer la variation, de la tension haute fréquence avec la variation de phase. En effet, connaissant pour une même série de fabrication l'amplitude maximale de la variation de fréquence adiabatique, on peut calibrer la courbe de modulation de la tension laser et déterminer ainsi la valeur de phase à obtenir.

Ainsi, d'une façon générale, l'invention consiste à modifier l'indice de réfraction dans une section laser prévue pour produire une onde laser, de façon à asservir la phase de l'onde fournie à une section de modulation.

En pratique, l'asservissement de la phase peut être réalisé en modifiant l'indice de réfraction dans cette section laser par injection d'un courant électrique de correction.

Telle que caractérisée, l'invention selon la revendication 1 concerne donc un dispositif d'émission optique comprenant un composant intégré comportant une section laser pour fournir une onde laser à une section de modulation prévue pour recevoir une tension de commande de modulation représentative d'un signal à émettre, ladite section laser comprenant au moins une section oscillateur ledit dispositif émettant des impulsions optiques avec une variation de fréquence adiabatique, caractérisé en ce que ladite tension de commande de modulation induisant une modulation de la tension entre les bornés de ladite section oscillateur, ledit dispositif comprend un circuit électronique pour ajuster un courant électrique injecté dans la section laser en réponse à une mesure de tension correspondante à l'amplitude de ladite modulation induite de tension, de sorte à obtenir une valeur desirée pour l'amplitude de la variation de fréquence adiabatique.

Le circuit électronique sera donc conçu de façon à éviter de prendre en compte les fluctuations de tension ayant d'autre cause que la modulation d'émission de signal. En particulier, sa constante de temps devrait être en tout cas suffisante (supérieure à 10ns) pour s'affranchir des oscillations de relaxation dues à l'émission spontanée (bruit de phase).

Dans un premier mode de réalisation de l'invention, on agit directement sur le courant électrique d'injection. Il dans la section oscillateur. La densité de porteurs étant maintenue fixe au delà du seuil d'oscillation, l'asservissement de l'indice de réfraction dans la section oscillateur par le courant I1 se produit par effet thermique. Ceci n'est pas sans conséquence sur la puissance optique, mais ne pose pas de problème dans des applications à des dispositifs d'émission optique à amplificateurs en régime saturé.

Pour des applications de transmission optique utilisant des amplificateurs en régime linéaire, on préfère un deuxième mode de réalisation de l'invention, dans lequel la puissance optique est inchangée. Dans ce deuxième mode de réalisation de l'invention, la section laser comprend une section de contrôle de phase couplée à la section oscillateur. Cette section de contrôle de phase est placée entre la section oscillateur et la section de modulation et elle est de même constitution que la section de modulation (même structure verticale et même compositions des couches semi-conductrices). Cette section de contrôle de phase est commandée en courant par le circuit électronique de commande pour modifier son indice de réfraction par modification de la densité de porteurs. On asservit ainsi la phase sans effet thermique, moyennant la réalisation d'une section de contrôle de phase. Cette section de contrôle de phase étant de même constitution que la section de modulation, il n'y a cependant pas d'étapes de procédé supplémentaires. Il suffit simplement de prévoir l'existence d'une électrode supplémentaire lors du dessin du masque de définition des électrodes.

En modifiant l'indice de réfraction dans la section laser, on modifie légèrement la valeur de la longueur d'onde λₗ dans cette section. Mais cette variation est de l'ordre de 1 nanomètre en pratique, sans conséquence aucune pour la différence de 10 à 30 nanomètres nécessaire entre les longueurs d'onde λₗ et λₘ, pour que la section de modulation soit transparente pour l'émission laser.

D'autres particularités et avantages de l'invention apparaîtront à la lecture de la description donnée à titre d'exemple illustratif mais non limitatif, et faite en référence aux dessins annexés dans lesquels :
- la figure 1, déjà décrite, représente schématiquement une structure d'un dispositif ILM intégré de l'état de la technique,
- la figure 2 représente les trois types de variation de fréquence de l'impulsion optique en sortie de section de modulation,
- les figures 3 et 4 représentent chacune la courbe de modulation en petits signaux de la puissance laser (face arrière) en fonction de la fréquence de modulation de la section de modulation,
- la figure 5 représente un premier mode de réalisation de l'invention,
- la figure 6 représente un deuxième mode de réalisation de l'invention,
- la figure 7 montre une courbe d'amplitude de la variation de fréquence adiabatique en fonction de la phase de sortie et
- la figure 8 montre la forme d'un train d'impulsions optiques obtenu selon l'invention, avec une variation de fréquence adiabatique ramenée à une valeur nulle.

Dans tout le reste de la description, les mêmes références sont utilisées pour désigner les mêmes éléments.

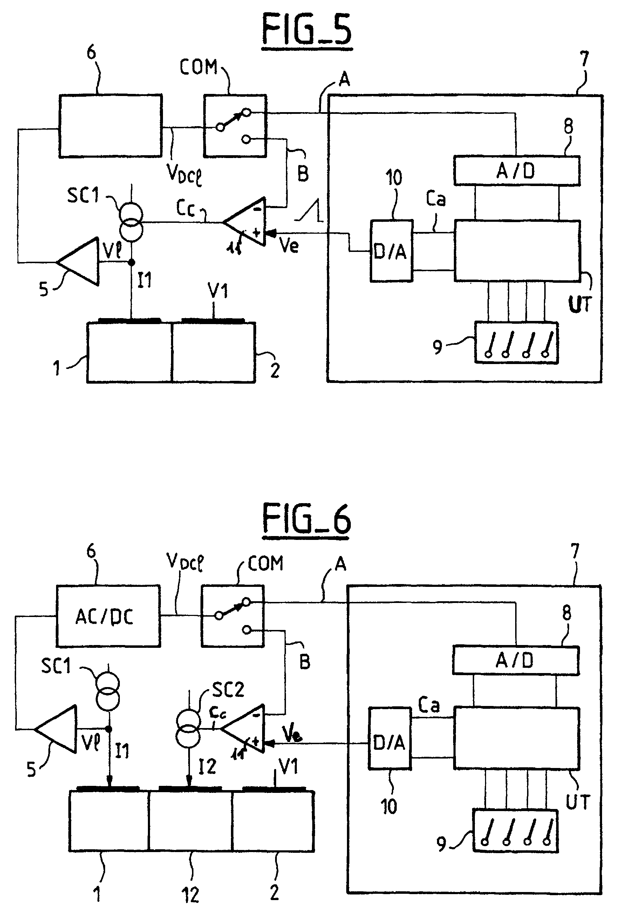

La figure 5 représente un premier mode de réalisation de l'invention. Le dispositif ILM comporte une première section prévue pour fournir une onde laser et une deuxième section de modulation 2. Dans ce premier mode de réalisation de l'invention, la première section est seulement formée d'une section oscillateur 1. Une source de courant continu SC1 injecte un courant électrique I1 transversalement dans la section oscillateur 1. Des moyens de modulation non représentés appliquent aux bornes de la section de modulation 2 une tension polarisée en inverse V1 et modulée en tout ou rien. Des moyens de mesure de l'amplitude de modulation de la tension V*1* aux bornes de la section oscillateur comprennent un amplificateur haute fréquence 5 et un convertisseur de tension alternatif/continu 6.

L'amplificateur de tension haute fréquence 5 reçoit en entrée la tension Vₗ prise aux bornes de la section oscillateur 1 et fournit en sortie la composante alternative de cette tension. Il est suivi du convertisseur de tension alternatif/continu 6 qui fournit la tension continue V_{DC*l*} dont le niveau correspond à l'amplitude de la composante alternative de la tension V_{*l*} et qui constitue donc une mesure de l'amplitude de la modulation de cette tension V_{*l*}.

Comme signalé précédemment, le convertisseur 6 présente une bande passante adaptée à la fois pour mesurer la modulation de signal et pour filtrer les fluctuations dues à l'émission spontanée de sorte que la constante de temps de la boucle de régulation soit en tout cas supérieure à 10 ns environ, mais compte tenu du phénomène à corriger, elle peut être choisie bien plus élevée.

Cette tension continue V_{DC}_{*l*} est appliquée en entrée d'un commutateur COM à deux voies de sortie. Une première voie A est une entrée de mesure d'un circuit d'asservissement 7 de la phase Ω du dispositif ILM. Ce circuit d'asservissement 7 délivre en sortie un niveau de tension analogique d'asservissement Ve appliquée sur une entrée non inverseuse (+) d'un amplificateur différentiel 11.

La deuxième voie B est appliquée sur l'entrée inverseuse (-) de l'amplificateur différentiel 11. Cet amplificateur différentiel fournit en sortie une commande de variation en courant C_{C} appliquée à la source de courant continu SC1, pour ajuster la valeur du courant électrique I1.

Le circuit d'asservissement 7 comprend une unité de traitement UT qui reçoit d'un convertisseur analogique/numérique 8 la valeur numérique de la tension V_{DC*l*}. De préférence, un registre de donnée 9 configurable par exemple au moyen d'interrupteurs est associé à l'unité de traitement.

L'unité de traitement délivre sa consigne numérique d'asservissement C_{A} vers un convertisseur numérique analogique 10, qui délivre en sortie la tension analogique de consigne Ve appliquée sur l'entrée non inverseuse de l'amplificateur différentiel 11.

Le circuit de contrôle du dispositif ILM a deux modes de fonctionnement, un mode de calibration et un mode automatique.

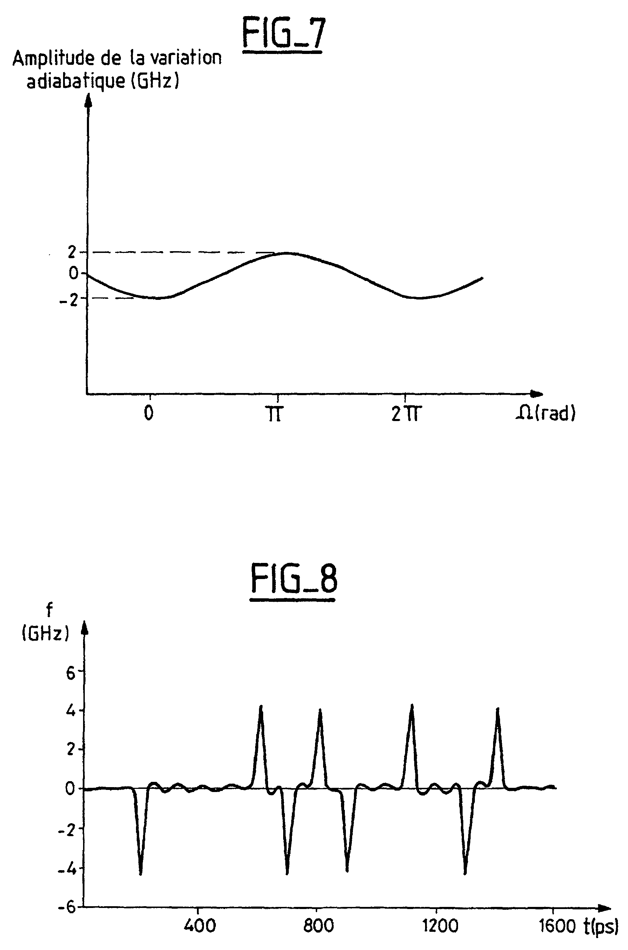

Le premier mode de fonctionnement est un mode de calibration, qui consiste à relever dans l'unité de traitement la courbe de l'amplitude de la modulation de la tension aux bornes de la section laser en fonction du courant électrique continu I1. Pour cela on fait varier ce courant entre deux valeurs extrêmes, de manière à balayer la courbe représentée à la figure 7. Dans ce mode, c'est la voie A du commutateur qui est sélectionnée. L'amplificateur différentiel reçoit seulement la tension analogique de consigne Ve fonction de la consigne C_{A}.

Quand cette courbe est relevée, l'unité de traitement détermine la valeur de la consigne numérique d'asservissement C_{A} pour laquelle on a une amplitude nulle de la modulation de la tension. Le circuit peut alors passer en mode automatique. Dans ce mode, c'est la voie B qui est validée. L'unité de traitement applique la consigne d'asservissement Cₐ déterminée. La boucle de réaction avec l'amplificateur différentiel 11 est opérationnelle : la valeur du courant I1 est ajustée en permanence, par le contrôle en temps réel de l'amplitude de la modulation de la tension laser. En pratique, la variation de courant nécessaire est de l'ordre de 50 à 100 milliampères.

Il peut être intéressant dans certaines applications de pouvoir choisir une amplitude de variation de fréquence adiabatique différente de zéro. En mode de calibration, on utilise alors le registre de donnée 9 pour y programmer l'amplitude maximale (amplitude crête) de variation de fréquence adiabatique du dispositif ILM, par exemple 2Ghz. On a vu en effet que l'on connaît cette valeur pour une série de fabrication. A titre d'illustration, la figure 7 montre une courbe de l'amplitude de la variation de fréquence adiabatique avec la phase Ω. Dans cet exemple, l'amplitude maximale est de 2Ghz. Cette valeur maximale est égale aussi à 2Ghz pour tous les dispositifs ILM d'une même série de fabrication.

Comme la variation de la modulation de tension avec la phase suit la même variation périodique entre 0 et 2π que l'amplitude de la variation de fréquence adiabatique avec la phase, l'unité de traitement peut calibrer la courbe mesurée : à la variation maximum de la modulation de la tension, elle fait correspondre l'amplitude maximum de la variation de fréquence adiabatique.

En mode automatique, on peut alors programmer dans le registre de données l'amplitude de variation de fréquence adiabatique voulue, par exemple 0Ghz, 0.5Ghz ou 1Ghz. L'unité de traitement pourra alors déterminer avec sa courbe calibrée la consigne numérique d'asservissement C_{A} à appliquer.

On a vu que ce mode de réalisation de l'invention n'est intéressant en pratique que dans des applications d'émission optique utilisant des amplificateurs optiques en régime saturé. En effet, l'asservissement de la phase par le courant d'injection I1 agit par effet thermique dans la section laser, faisant varier la puissance optique.

Un autre mode de réalisation laisse invariante cette puissance. Dans ce deuxième mode de réalisation qui est représenté sur la figure 6, la section laser du dispositif ILM prévue pour fournir une onde laser comprend une section de contrôle de phase 12 couplée à la section oscillateur 1. Cette section de contrôle de phase 12 est de même constitution que la section de modulation 2 et elle est placée entre la section laser 1 et la section de modulation 2. Une source de courant continu SC2 injecte dans cette section de contrôle de phase 12 un courant transversal I2 polarisé en sens direct, ce qui permet de modifier la densité de porteurs dans cette section. C'est la source de courant SC2 qui, dans ce mode de réalisation, est commandée par la sortie C_{C} de l'amplificateur différentiel 11.

Ce deuxième mode de réalisation de l'invention nécessite certes une section supplémentaire. Mais cette section étant de composition identique à la section de modulation, il n'y a pas d'étapes supplémentaires dans le procédé de fabrication.

L'asservissement de la phase selon l'invention permet de réduire ou d'annuler la variation de fréquence adiabatique et les oscillations, comme représenté sur la figure 8 pour une amplitude nulle de variation de fréquence adiabatique. Cet asservissement reste cependant sans effets sur les variations de fréquence transitoires. Des circuits de correction des variations de fréquence transitoires peuvent donc être avantageusement combinés au dispositif d'émission selon l'invention.

## Revendications

1. Dispositif d'émission optique comprenant un composant intégré comportant une section laser (1, 12) pour fournir une onde laser à une section de modulation (2) prévue pour recevoir une tension de commande de modulation (V₁) représentative d'un signal à émettre, ladite section laser (1, 12) comprenant au moins une section oscillateur (1) ledit dispositif émettant des impulsions optiques avec une vaviation de fréquence adiabatique, **caractérisé en ce que** ladite tension de commande de modulation (V₁) induisant une modulation de la tension (V₁) entre les bornes de ladite section oscillateur (1), ledit dispositif comprend un circuit électronique (5, 6, 7, 11) pour ajuster un courant électrique (I1, I2) injecté dans la section laser (1, 12) en réponse à une mesure de tension (V_{DCl}) correspondante à l'amplitude de ladite modulation induite de tension (V₁), de sorte à obtenir une valeur desirée pour l'amplitude de la variation de fréquence adiabatique.

2. Dispositif d'émission optique selon la revendication 1, **caractérisé en ce que** ledit courant ajusté est fourni par une source de courant continu (SC1) appliquant un courant électrique transversal (I1) à ladite section oscillateur (1).

3. Dispositif d'émission optique selon la revendication 1, **caractérisé en ce que** ladite section laser (1, 12) comprend une section de contrôle de phase (12) placée entre la section oscillateur (1) et la section de modulation (2), ladite section de contrôle de phase (12) étant de même constitution que la section de modulation (2), et **en ce que** ledit courant ajusté est fourni par une source de courant continu (SC2) appliquant un courant électrique transversal (I2) à ladite section de contrôle de phase (12).

4. Dispositif d'émission optique selon l'une ou l'autre des revendications 2 et 3, **caractérisé en ce que** le circuit électronique de commande comporte des moyens de mesure (5, 6) de l'amplitude (V_{DC}_{*l*}) de la modulation de la tension (V_{*1*}) aux bornes de la section oscillateur (1) et un amplificateur différentiel (11) recevant sur une entrée non-inverseuse (+) une tension de consigne d'asservissement (Ve) et sur une entrée inverseuse (-) ladite mesure (V_{D}_{*Cl*}) d'amplitude de la modulation, ledit amplificateur fournissant en sortie une commande (C_{C}) de variation en courant.

5. Dispositif d'émission optique selon la revendication 4, **caractérisé en ce que** le circuit électronique de commande comprend un circuit d'asservissement (7) comprenant une unité de traitement (UT) apte à fournir en sortie ladite tension de consigne d'asservissement (Ve) et à relever des mesures de la modulation d'amplitude de la tension (V_{*1*}) aux bornes de la section oscillateur 1, un commutateur (COM) étant prévu pour appliquer sélectivement ladite mesure (V_{DC}_{*l*}) d'amplitude de modulation sur une première voie (A) vers ladite unité de traitement (UT) en mode de calibration.

6. Dispositif d'émission optique selon la revendication 5, **caractérisé en ce que** le circuit d'asservissement (7) comprend un registre de données configurable (9) pour fournir la valeur maximale de l'amplitude de la variation de fréquence adiabatique du composant intégré en mode de calibration.

7. Dispositif d'émission selon la revendication 6, **caractérisé en ce que** dans un mode automatique, la mesure d'amplitude (V_{DC}_{*l*}) est appliquée sur l'entrée inverseuse de l'amplificateur différentiel (11) par une deuxième voie (B) du commutateur (COM), le registre de donnée (9) contenant alors la valeur désirée de l'amplitude de la variation de fréquence adiabatique.

## Claims

1. A light emitter device comprising an integrated component having a laser section (1, 12) for supplying a laser wave to a modulator section (2) designed to receive modulation control voltage (V_{*l*}) representative of a signal to be emitted, said laser section (1, 12) comprising at least one oscillator section (1), said device being capable of emitting light pulses presenting adiabatic frequency variation, the device being **characterized in that** since said modulation control voltage (V_{*l*}) induces voltage modulation (V_{*l*}) across the terminals of said oscillator section (1), said device comprises an electronic circuit (5, 6, 7, 11) for adjusting an electric current (I1, I2) injected into the laser section (1, 12) in response to measuring voltage corresponding to the amplitude (V_{DC}_{*l*}) of said induced modulation of voltage (V_{*l*}), so as to obtain a desired value for the amplitude of the adiabatic frequency variation.

2. A light emitter device according to claim 1, **characterized in that** said adjusted current is supplied by a DC current source (SC1) applying a transverse electric current (I1) to said oscillator section (1)

3. A light emitter device according to claim 1, **characterized in that** said laser section (1, 12) comprises a phase control section (12) placed between the oscillator section (1) and the modulator section (2), said phase control section (12) being of the same structure as the modulator section (2), and **in that** said adjusted current is supplied by a DC current source (SC2) applying a transverse electric current (12) to said phase control section (12).

4. A light emitter device according to claim 2 or 3, **characterized in that** the electronic control circuit includes means (5, 6) for measuring the amplitude (V_{DC}_{*l*}) of the modulation of the voltage (V_{*l*}) across the terminals of the oscillator section (1) and a differential amplifier (11) receiving a servo-control set voltage (Ve) on a non-inverting input (+) and said measured amplitude (V_{DC}_{*l*}) of the modulation on an inverting input (-), said amplifier outputting a current-varying control signal (C_{c}).

5. A light emitter device according to claim 4, **characterized in that** the electronic control circuit comprises a servo-control circuit (7) comprising a processor unit (UT) suitable for outputting said servo-control set voltage (Ve) and for measuring the amplitude modulation of the voltage (V_{*l*}) across the terminals of the oscillator section (1), a switch (COM) being provided. selectively to apply said measurement (V_{DC}_{*l*}) of the modulation amplitude to a first outlet (A) leading to said processor unit (UT) in a calibration mode.

6. A light emitter device according to claim 5, **characterized in that** the servo-control circuit (7) includes a configurable data register (9) for supplying the maximum value for the amplitude of adiabatic frequency variation of the integrated component, in calibration mode.

7. An emitter device according to claim 6, **characterized in that** in an automatic mode, the amplitude measurement (V_{DC}_{*l*}) is applied to the inverting input of the differential amplifier (11) via a second outlet (B) of the switch (COM), the data register (9) then containing the value desired for the amplitude of adiabatic frequency variation.

## Patentansprüche

1. Optische Emissionsvorrichtung mit einer integrierten Komponente, die einen Laserabschnitt (1, 12) zum Liefern einer Laserwelle an einen Modulationsabschnitt (2) umfasst, der vorgesehen ist, um eine Modulationssteuerspannung (V₁) zu empfangen, die für ein zu emittierendes Signal repräsentativ ist, wobei der Laserabschnitt (1, 12) wenigstens einen Oszillatorabschnitt (1) umfasst und die Vorrichtung in der Lage ist, optische Impulse zu emittieren, die eine adiabatische Frequenzänderung aufweisen, **dadurch gekennzeichnet, dass** die Modulationsspannung (V₁) eine Modulation der Spannung (V₁) zwischen den Klemmen des Oszillatorabschnitts (1) induziert, die Vorrichtung eine elektronische Schaltung (5, 6, 7, 11) umfasst zum Anpassen eines in den Laserabschnitt (1, 12) eingespeisten elektrischen Stroms (I1 I2) in Reaktion auf eine Messung der Spannung (V_{DCl}), die der Amplitude der induzierten Modulation der Spannung (V₁) entspricht, um einen gewünschten Wert für die Amplitude der adiabatischen Frequenzänderung zu erhalten.

2. Optische Emissionsvorrichtung nach Anspruch 1, **dadurch gekennzeichnet, dass** der angepasste Strom von einer Gleichstromquelle (SC1) geliefert wird, die einen elektrischen Querstrom (II) an den Oszillatorabschnitt (1 anlegt.

3. Optische Emissionsvorriohtung nach Anspruch 1, **dadurch gekennzeichnet, dass** der Laserabschnitt (1, 12) einen Phasensteuerabschnitt (12) umfasst, der zwischen dem Oszillatorabschnitt (1 und dem Modulationsabschnitt (2) angeordnet ist, wobei der Phasensteuerabschnitt (12) den gleichen Aufbau wie der Modulationsabschnitt (2) hat, und dass der angepasste Strom von einer Gleichstromquelle (SC2) geliefert wird, die einen elektrischen Querstrom (12) an den Phasensteuerabschnitt (12) anlegt.

4. Optische Emissionsvorrichtung nach Anspruch 2 oder 3, **dadurch gekennzeichnet, dass** die elektronische Steuerschaltung Mittel (5, 6) zum Messen der Amplitude (V_{DCl}) der Modulation der Spannung (V₁) an den Klemmen des Oszillatorabschnitts (1) und einen Differenzverstärker (11) umfasst, der einem nichtinvertierenden Eingang (+) eine Steuerungs-Sollspannung (Ve) und an einem invertierenden Eingang (-) den Messwert (V_{DC}l) der Amplitude der Modulation empfängt, wobei der Verstärker am Ausgang einen Stromänderungsbefehl (C_{c}) liefert.

5. Optische Emissionsvorrichtung nach Anspruch 4, **dadurch gekennzeichnet, dass** die elektronische Steuerschaltung eine Regelschaltung (7) umfasst, die eine Verarbeitungseinheit (UT) umfasst, die in der Lage ist, am Ausgang die Regelungs-Sollspannung (Ve) zu liefern und Messwerte der Amplitudenmodulation der Spannung (V₁) an den Klemmen des Oszillatorabschnitts (1) abzugreifen, und ein Schalter (COM) vorgesehen ist, um selektiv den Messwert (V_{DCl}) der Amplitude der Modulation auf einem ersten Kanal (A) an die Verarbeitungseinheit (UT) im Kalibriermodus anzulegen.

6. Optische Vorrichtung nach Anspruch 5, **dadurch gekennzeichnet, dass** die Regelschaltung (7) ein konfigurierbares Datenregister (9) zum Liefern des Maximalwertes der Amplitude der adiabatischen Frequenzänderung der integrierten Komponente im Kalibriexmodus umfasst.

7. Vorrichtung nach Anspruch 6, **dadurch gekennzeichnet, dass** in einem automatischen Modus der Messwert der Amplitude (V_{DCl}) an den invertierenden Eingang des Differenzverstärkers (11) über einen zweiten Kanal (B) des Schalters (COM) angelegt ist, wobei das Datenregister (9) dann den gewünschten Wert der Amplitude der adiabatischen Frequenzänderung enthält.
